(19) Europäisches Patentamt
European Patent Office
Office européen des brevets

(11) **EP 2 591 513 B1**

(12) **FASCICULE DE BREVET EUROPEEN**

(45) Date de publication et mention
de la délivrance du brevet:
**06.08.2014 Bulletin 2014/32**

(21) Numéro de dépôt: **11744044.6**

(22) Date de dépôt: **04.07.2011**

(51) Int Cl.:
***H01L 35/30*** *(2006.01)*

(86) Numéro de dépôt international:
**PCT/FR2011/000392**

(87) Numéro de publication internationale:
**WO 2012/004472 (12.01.2012 Gazette 2012/02)**

(54) **DISPOSITIF DE GÉNÉRATION DE COURANT ET/OU DE TENSION À BASE DE MODULE THERMOÉLECTRIQUE DISPOSÉ DANS UN FLUX DE FLUIDE**

VORRICHTUNG ZUR ERZEUGUNG VON STROM UND/ODER SPANNUNG AUF BASIS EINES IN EINER FLIESSENDEN FLÜSSIGKEIT PLATZIERTEN THERMOELEKTRISCHEN MODULS

DEVICE FOR GENERATING CURRENT AND/OR VOLTAGE BASED ON A THERMOELECTRIC MODULE PLACED IN A FLOWING FLUID

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.07.2010 FR 1002847**

(43) Date de publication de la demande:
**15.05.2013 Bulletin 2013/20**

(73) Titulaire: **Commissariat à l'Énergie Atomique et aux Énergies Alternatives 75015 Paris (FR)**

(72) Inventeurs:
• **SIMON, Julia**
**F-38100 Grenoble (FR)**
• **GAROFF, Tristan**
**F-38610 Gières (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
**EP-A2- 1 530 243     JP-A- 2001 065 858**

## Description

### Domaine technique de l'invention

L'invention est relative à un dispositif de génération de courant et/ou de tension comportant :

- des moyens pour faire circuler un fluide entre une entrée et une sortie du dispositif,
- un module thermoélectrique comportant une première face active exposée au fluide, le module thermoélectrique étant ajouré et disposé dans le chemin du fluide entre l'entrée et la sortie du dispositif, la première face active étant sensiblement perpendiculaire à la direction d'écoulement du fluide.

### État de la technique

La thermoélectricité connaît un regain d'intérêt pour les applications de génération de puissance, notamment dans l'environnement industriel où la majeure partie de l'énergie consommée est dissipée sous forme thermique de manière inutile. La chaleur dissipée est souvent véhiculée par des médias gazeux ou liquides avec des températures de l'ordre de 100°C rendant les solutions de récupération d'énergie peu efficaces et difficiles à mettre en oeuvre.

Afin de récupérer une partie de l'énergie drainée, il a été développé des modules thermoélectriques permettant d'entourer des conduites véhiculant des produits ou gaz à hautes températures.

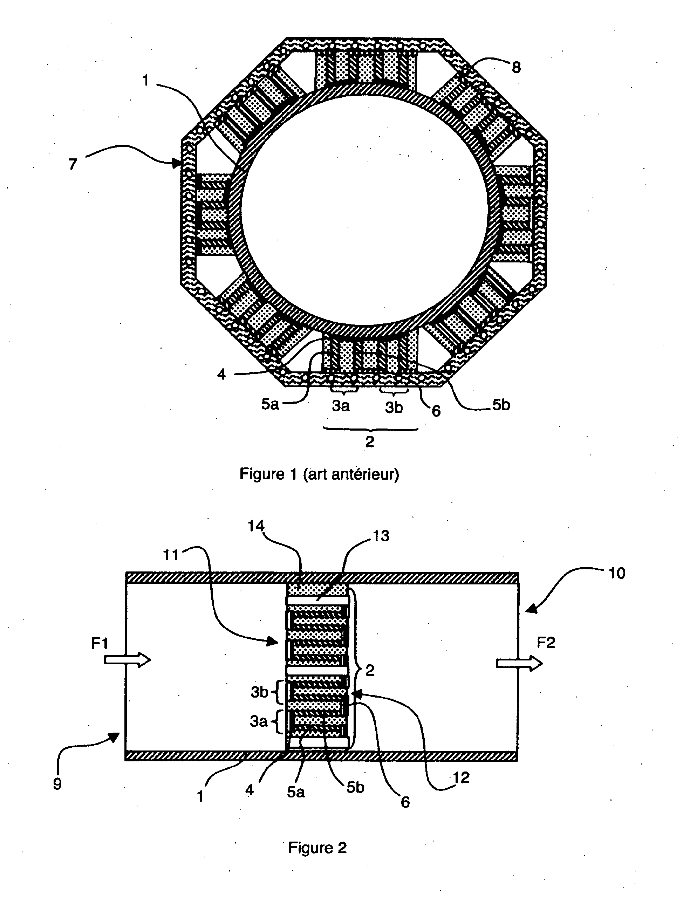

Comme illustré à la figure 1, un tel dispositif vu en coupe transversale comporte une conduite 1 dans laquelle se déplace un fluide (perpendiculairement au plan de la feuille pour la figure 1) à haute température formant une source chaude. La surface extérieure de la conduite 1 est habillée par une pluralité de modules thermoélectriques 2 élémentaires comportant chacun des thermocouples 3a, 3b reliés électriquement en série et thermiquement en parallèle de sorte à former au niveau d'une première face du module des jonctions chaudes et au niveau d'une seconde face du module, opposée à la première face, des jonctions froides. Les jonctions chaudes sont représentées par des éléments de connexion 4 reliant électriquement deux plots 5a, 5b en matériau thermoélectrique pour former un thermocouple. Les jonctions froides sont représentées à la figure 1 par des éléments de liaison 6 reliant en série deux thermocouples adjacents. Sur la figure 1, la première face du module est incurvée de sorte à épouser la surface extérieure de la conduite 1. La conduite 1 est insérée dans un échangeur thermique 7 de forme polygonale comportant des tuyaux internes 8 de circulation d'un liquide de refroidissement. La seconde face de chaque module 2 est en contact thermique avec cet échangeur thermique 7 afin d'optimiser le gradient de température entre les jonctions chaudes et les jonctions froides. L'exploitation du gradient thermique permet alors soit de générer du courant par effet Seebeck, soit d'alimenter une charge en fonction « récupération d'énergie », soit de mesurer une tension en fonction « capteur ».

Dans le dispositif décrit ci-dessus, les modules thermoélectriques étant disposés autour de la conduite 1, la résistance thermique de la conduite 1 est responsable d'une diminution de la température au niveau de la jonction chaude. Dès lors, en fonction de la taille de la conduite 1, de l'épaisseur de la conduite 1 et des matériaux utilisés, le gradient de température sera plus ou moins optimisé.

Le document JP2001065858 décrit un dispositif ayant un gaz traversant des éléments thermoélectriques.

### Objet de l'invention

L'objet de l'invention vise la réalisation d'un dispositif de génération de courant et/ou de tension optimisant la récupération d'énergie lorsque l'une des sources d'énergie se présente sous la forme d'un fluide en déplacement.

On tend vers ce but par les revendications annexées et plus particulièrement en ce que le module thermoélectrique comprend des thermocouples, chaque thermocouple comportant deux plots électriquement conducteurs reliés électriquement entre eux au niveau de la première face active du module thermoélectrique pour former une jonction chaude ou froide associée, les thermocouples étant reliés électriquement en série au niveau d'une deuxième face active du module pour former des jonctions complémentaires, et en ce que les thermocouples sont intégrés dans un substrat isolant thermiquement, le module thermoélectrique étant ajouré par des trous débouchant réalisés dans le substrat.

Selon un mode de réalisation, le module comporte une matrice de trous reliant la première face active à la deuxième face active, un plot de thermocouple étant adjacent à quatre trous.

Selon un autre mode de réalisation, le modulé comporte une série de trous en quinconce reliant la première face active à la deuxième face active, un plot de thermocouple étant adjacent à trois trous.

Selon un autre mode de réalisation, le module comporte une matrice de trous reliant la première face active à la deuxième face active, un ensemble de quatre plots de thermocouples étant entouré par quatre trous, chaque plot étant adjacent à deux trous de ces quatre trous.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre un dispositif de génération de courant selon l'art antérieur.

Les figures 2 à 4 illustrent différents modes de réalisation d'un dispositif selon l'invention.

Les figures 5 et 6 illustrent deux implémentations particulières d'un dispositif selon l'invention dans une armoire informatique.

Les figures 7 à 10 illustrent différents modes de réalisation de la géométrie du module thermoélectrique utilisé dans l'invention.

**Description de modes préférentiels de réalisation**

Contrairement aux dispositifs de l'art antérieur où les modules thermoélectriques sont disposés hors du flux de la source chaude ou froide et entourent les conduites dans lequel circule le fluide, le dispositif décrit ci-après comporte un module thermoélectrique directement placé et traversé par le fluide chaud ou froid pour y exploiter un gradient de température, tout en limitant la perturbation de l'écoulement du fluide. Le module thermoélectrique peut fournir du courant et/ou une tension. Selon l'application, l'un ou l'autre ou les deux paramètres (puissance) peuvent être utilisés.

Comme illustré aux figures 2 à 4 qui sont des coupes longitudinales du dispositif, le dispositif de génération de courant et/ou de tension comporte des moyens pour faire circuler un fluide entre une entrée 9 et une sortie 10 du dispositif. Ces moyens de circulation du fluide peuvent être un ventilateur, une pompe, ou tout autre type de moyens mis en place par l'homme du métier pour permettre la circulation du fluide. Un module thermoélectrique 2 ajouré est disposé dans le chemin du fluide (représenté par les flèches F1 et F2) entre l'entrée 9 et la sortie 10 du dispositif de sorte à ce que le fluide puisse traverser le module sans que ce dernier n'empêche la circulation du fluide. Le module thermoélectrique 2 comporte une première face active 11 exposée au fluide, ladite première face active 11 étant sensiblement perpendiculaire à la direction d'écoulement du fluide. Autrement dit, la première face active 11 fait face au fluide selon sa direction de circulation. En thermoélectricité, une face active d'un module est une face pouvant être équipée de jonctions chaudes ou froides aptes à exploiter un gradient de température pour générer un courant selon l'effet Seebeck et/ou une tension.

Sur lés figures 2 à 4, le module thermoélectrique est disposé dans une conduite 1. Cette conduite 1 peut acheminer un fluide, de type liquide ou gazeux selon le sens découlement indiqué par les flèches F1 et F2. Dans certaines applications, la conduite 1 peut ne pas être matérialisée. De plus, le dispositif peut avoir une taille inférieure à la section de déplacement du fluide.

Classiquement, le module thermoélectrique 2 peut comporter une pluralité de thermocouples 3a, 3b reliés électriquement en série et thermiquement en parallèle. Un thermocouple peut comporter deux plots 5a, 5b en matériaux électriquement conducteurs favorisant les effets thermoélectriques. Par exemple pour des températures de fluide comprises entre 20°C et 200°C on utilisera un alliage de BiTe, pour des températures comprises entre 300°C et 600°C un alliage de PbTe, et pour des températures supérieures à 600°C un alliage de Si-Ge. Généralement, les deux plots 5a, 5b d'un même thermocouple 3a comportent des matériaux différents et/ou dopé de type différent N ou P. De manière générale, chaque thermocouple 3a, 3b comporte deux plots 5a, 5b électriquement conducteurs reliés électriquement entre eux au niveau de la première face active 11 du module 2 pour former une jonction chaude ou froide associée (selon la température du fluide), les thermocouples 3a, 3b sont reliés électriquement en série au niveau d'une deuxième face active 12 du module, de préférence opposée à la première face active 11, pour former des jonctions complémentaires. Sur les figures 2 à 4, les deux plots 5a, 5b du thermocouple 3a sont reliés électriquement en série par un élément de connexion 4 électrique disposé, de préférence, au niveau de la première face active du module pour former une jonction chaude ou une jonction froide, selon si le fluide circulant dans la conduite 1 est chaud ou froid. Par chaud ou froid, on entend des températures telles qu'un gradient de température supérieur à 10°C s'établisse entre les deux faces actives du module thermoélectrique. Typiquement on travaille entre 10°C et plus de 1000°C, et de façon standard entre 10°C et 100°C Les thermocouples 3a, 3b sont ensuite reliés électriquement en série au niveau d'une deuxième face active 12 du module 2 pour former des jonctions complémentaires froides ou chaudes, en fonction du type des jonctions situées au niveau de la première face active 11 : ce lien peut être réalisé par des éléments de liaison 6 électriquement conducteurs situés au niveau de la seconde face active 12. Sur les figures 2 à 4, la première face active 11 est opposée et parallèle à la deuxième face active 12.

Le module thermoélectrique 2 ajouré peut comporter une pluralité de trous débouchant 13 reliant la première face active 11 du module 2 à la deuxième face active 12 du module 2.

De préférence, les thermocouples 3a, 3b sont intégrés dans un substrat 14 de préférence d'épaisseur sensiblement égale à la hauteur des thermocouples 3a, 3b ou à la hauteur des plots 5a, 5b des thermocouples 3a, 3b. Autrement dit, les éléments de connexion 4 et de liaison 6 peuvent affleurer au niveau du substrat 14 comme sur les figures 2 à 4, ou former des saillies (non représentées) de part et d'autre du substrat 14. Bien entendu, d'autres agencements peuvent être prévus par l'homme du métier.

Les trous débouchant 13 permettant le libre passage du fluide au travers du module thermoélectrique 2 peuvent alors être réalisés dans le substrat 14 qui se retrouve percé selon une géométrie particulière. Le substrat 14 choisi peut être de toute nature comme par exemple de la céramique, de l'oxyde, etc. Il est néanmoins avantageux de choisir un substrat de type polymère ou plastique permettant une certaine flexibilité, l'élaboration de composants de grande surface, et une perforation aisée pour former les trous. Le matériau utilisé pour le substrat 14 sera, de préférence, un bon isolant thermique de sorte à limiter la montée en température des plots 5a, 5b pour conserver un gradient de température optimum entre les deux faces actives 11, 12 du module thermoélectrique 2.

En fait, comme illustré aux figures 2 à 4, les plots 5a, 5b sont avantageusement enrobés par le substrat 14 le long de leur axe longitudinal. Les parois intérieures des trous débouchant 13 entre la première face active et la seconde face active 11, 12 sont délimitées par le substrat 14 qui est distinct des thermocouples. Autrement dit, lorsqu'un fluide traverse le module thermoélectrique 2 il ne vient pas lécher les plots 5a, 5b sur leur longueur.

Bien entendu, pour éviter les courts-circuits le matériau du substrat 14 est aussi électriquement isolant.

Selon le mode de réalisation de la figure 2, les jonctions chaudes ou froides, formées par des éléments de connexion 4 électrique, au niveau de la première face active 11 sont directement en contact avec le flux du fluide. Ainsi, la température au niveau de la première face active 11 sera plus proche de celle du fluide, contrairement à l'art antérieur où la conduite générait une perte de température. Afin d'éviter les courts-circuits, notamment dans le cas où le fluide est un liquide électriquement conducteur, la première face active 11 peut être recouverte par un film électriquement isolant et thermiquement conducteur, par exemple un feuillard fin de $100\mu m$ à $500\mu m$ d'aluminium anodisé ; bien entendu, tout type de moyens permettant d'éviter la mise en court-circuit des éléments de connexion 4 de la première face active 11 peuvent être utilisés par l'homme du métier.

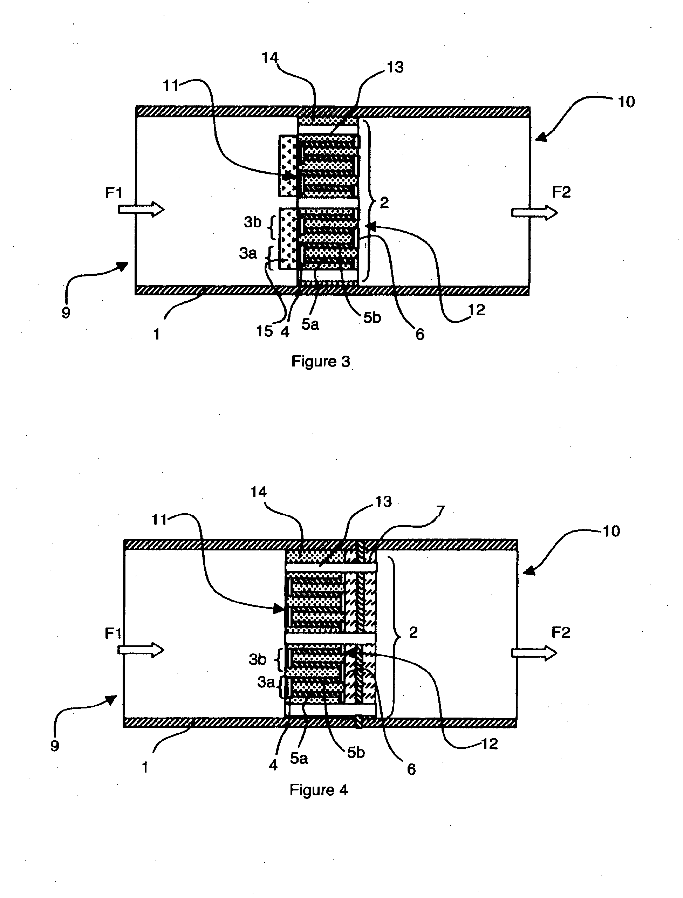

Selon un perfectionnement illustré à la figure 3 reprenant toutes les références de la figure 2, pour améliorer le rendement du dispositif, des moyens d'échange thermique 15 sont disposés au niveau de la première face active 11, de préférence en contact direct avec les jonctions chaudes ou froides de ladite première face active 11. Le rôle de ces moyens d'échange thermique 15 est de transférer de manière optimale le flux thermique du fluide circulant entre l'entrée 9 et la sortie 10 de sorte à maximiser la température des jonctions de la première face active 11 avec le moins de pertes possibles. Ces moyens d'échange thermique 15 peuvent être formés par des ailettes de différentes formes absorbant la chaleur du fluide. Par exemple, il peut être utilisé des ailettes droites (appelées radiateur) ou des ailettes ondulées. L'homme du métier aura compris que les moyens d'échange thermique 15 sont disposés et agencés de sorte à ne pas obturer les trous du module 2.

Selon un autre perfectionnement illustré à la figure 4, le dispositif comporte un échangeur thermique 7 en contact thermique avec la deuxième face active 12 du module thermoélectrique 2. Cet échangeur thermique 7 peut comprendre un radiateur à circulation d'eau, ou d'autre fluide caloporteur, servant à refroidir ou à réchauffer la deuxième face active 12 du module 2 en fonction de la température du fluide. L'échangeur thermique 7 est disposé et agencé de sorte à ne pas obturer les trous du module 2.

Bien entendu, il est possible de combiner les perfectionnements des figures 3 et 4 pour optimiser au mieux le gradient de température entre les première et deuxième faces actives 11, 12 du module thermoélectrique 2.

De manière générale, pour isoler, le cas échéant, électriquement la première face active 11 des moyens d'échange thermique 15 et la deuxième face active 12 de l'échangeur thermique 7, un matériau isolant électriquement et conducteur thermiquement sera placé à l'interface respective de ces derniers. Un tel matériau peut par exemple être le même feuillard fin d'aluminium anodisé que celui évoqué précédemment.

Afin de valider les perfectionnements de la figure 4 et de la combinaison des figures 3 et 4, il a été réalisé une armoire informatique de 1,8m de haut sur 1 m de large dans laquelle les appareils génèrent un air chaud d'environ 60°C, fournissant ainsi une puissance thermique de l'ordre de 30kW. Une paroi de l'armoire est percée de trous débouchant sur environ 70% de la surface de la paroi ($1,8m^2$ dans l'exemple) pour permettre le passage de l'air de l'intérieur de l'armoire, formant alors l'entrée, à l'extérieur de l'armoire, formant alors la sortie.

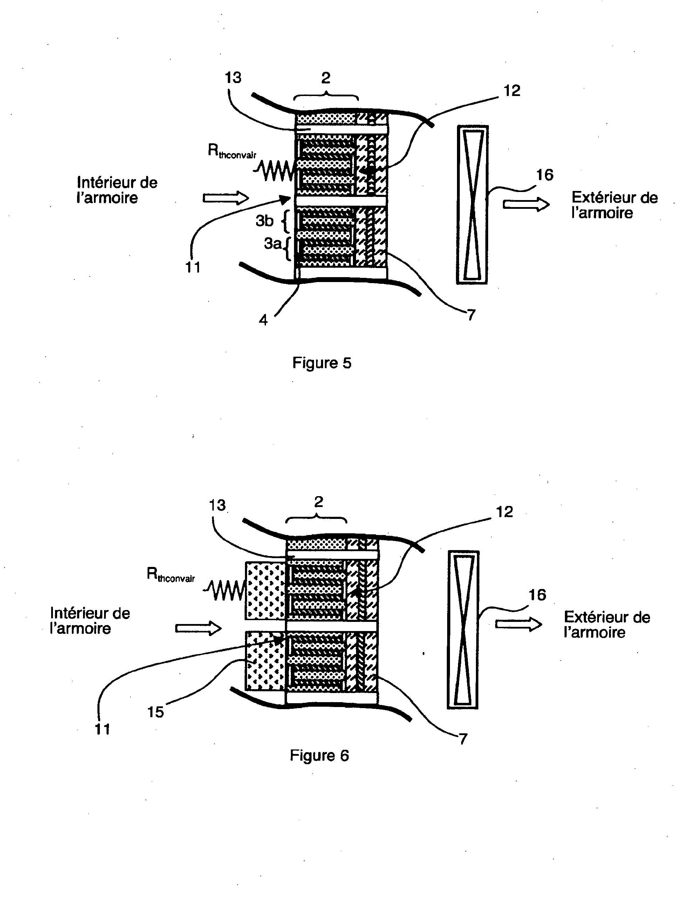

Les figures 5 et 6 illustrent deux types d'implémentations, sur ces figures, le flux d'air peut être généré par un ventilateur 16, par exemple d'extraction disposé le long de la paroi, par exemple à l'extérieur de l'armoire dans l'exemple particulier de réalisation. La paroi est équipée d'un système de refroidissement, formant l'échangeur thermique 7 du dispositif de génération de courant et/ou de tension, à base de circulation d'un liquide froid à 7°C. Le module thermoélectrique 2 est placé dans l'armoire collé contre la paroi, la première face active 11 du module étant orientée vers l'intérieur de l'armoire et la seconde face active 12 du module étant en contact avec la paroi, c'est-à-dire l'échangeur thermique 7. Les trous pratiqués dans le module sont formés au niveau des trous de la paroi, le taux de remplissage des thermocouples est de 50% sur les 30% de surface disponible de la paroi.

Dans un premier cas illustré à la figure 5, les thermocouples 3a, 3b ont leurs jonctions chaudes (représentées par les éléments de connexion 4) directement en contact avec le flux d'air, la résistance thermique $R_{thconvair}$ est alors d'environ 0,06K/W selon $R_{thconvair} = 1/(h*S)$ avec h = 30W/m²/K, S = 30% de $1,8m^2$. Du côté de l'échangeur thermique 7, la résistance thermique entre la deuxième face active 12 du module et le liquide de refroidissement est égale à $R_{théchangeur} = 1/(h*S) = 0,006K/W$ avec h = 300W/m²K et S= 30% de $1,8m^2$.

Dans un deuxième cas illustré à la figure 6, des moyens d'échange thermique 15 ont été rajoutés, par rapport à la figure 5, au niveau de la première face active 11 pour optimiser la température sur les jonctions chaudes. Ces moyens d'échange thermique 15 peuvent être des ailettes multipliant par vingt la surface d'échange S. Selon ce montage, on obtient $R_{thconvair}$ = 0,003K/W avec h toujours égal à 30W/m$^2$/K et S = 30% de 1,8m$^2$ multiplié par vingt.

Selon un troisième cas (non représenté), l'échangeur thermique 7 de la figure 6 est optimisé en utilisant un mur froid, c'est-à-dire un échangeur avec circulation de liquide de refroidissement au plus près des jonctions froides du module thermoélectrique. Ceci permet de réduire la résistance thermique entre le module et le liquide de refroidissement par exemple d'un facteur 10. De tels moyens peuvent être réalisés par un échangeur à plaque en contact direct avec les jonctions associées, ou d'autres types d'échangeurs assurant la même fonction. Selon ce montage, on obtient $R_{théchangeurmur}$ = 0,1*Rthéchangeur = 0,0006K/W.

Dans le premier cas, la puissance thermique est de 1400W pour une température au niveau des jonctions chaudes de 21°C, et une température de 16°C au niveau des jonctions froides. La puissance électrique générée est de 7,5 W pour un taux de recouvrement de 30%, et de 15W pour un taux de recouvrement de 50%.

Dans le deuxième cas, la puissance thermique est de 5200W pour une température au niveau des jonctions chaudes de 53°C, et une température de 37°C au niveau des jonctions froides. La puissance électrique générée est de 80W pour un taux de recouvrement de 30%, et de 130W pour un taux de recouvrement de 50%.

Dans le troisième cas, la puissance thermique est de 10000W pour une température au niveau des jonctions chaudes de 55°C, et une température de 25°C au niveau des jonctions froides. La puissance électrique générée est de 270W pour un taux de recouvrement de 30%, et de 450W pour un taux de recouvrement de 50%.

Ainsi, l'utilisation de moyens d'échange thermique 15 au niveau de la première face active 11 combinés à l'échangeur thermique 7 de la deuxième face active 12 permet de générer plus de courant et/ou de tension pour une même surface.

De préférence, la répartition des trous 13 et l'arrangement des thermocouples 3a, 3b respectent une certaine géométrie afin de permettre le fonctionnement du dispositif de génération de courant et/ou de tension tout en évitant de perturber au maximum l'écoulement du fluide

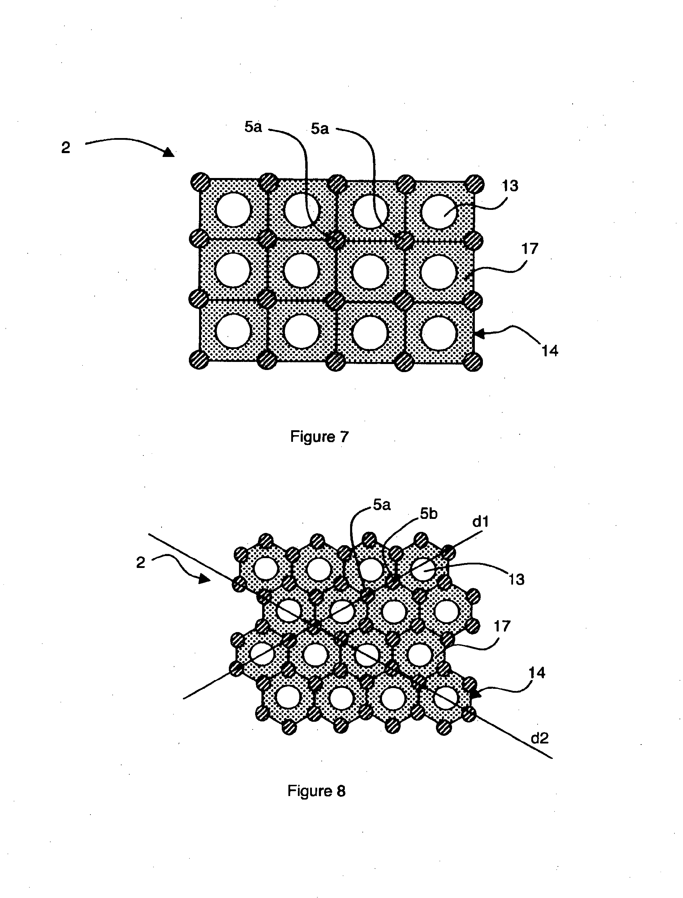

Les figures 7 à 10 illustrent quatre modes de réalisation du module thermoélectrique constituant en partie le dispositif de génération de courant et/ou de tension. Ces modes de réalisation sont illustrés par des vues en coupe du module, le fluide s'écoulant au travers du module perpendiculairement au plan de la feuille.

La figure 7 représente une vue en coupe du module selon un premier mode de réalisation, le module comporte une matrice de trous 13 reliant la première face active du module à la deuxième face active du module, c'est-à-dire des trous débouchant,, un plot 5a de thermocouple étant adjacent à quatre trous. Ce mode de réalisation peut être mis en oeuvre en subdivisant virtuellement en mailles 17 élémentaires le substrat 14 dans lequel sont formés les thermocouples. Les mailles élémentaires peuvent avoir une forme de cylindre, un cylindre peut être formé par une courbe génératrice fermée formée dans un plan et une courbe directrice gardant une direction fixe, perpendiculaire au plan, tout en passant par les points de la courbe génératrice. Sur la figure 7, les mailles 17 sont formées par un cylindre dont la courbe directrice forme un carré définissant au niveau de chaque maille 17 quatre arêtes de maille sensiblement perpendiculaire à la première face active et à la deuxième face active. Autrement dit, le cylindre comporte quatre latérales faces reliant la première et la deuxième face active. Au niveau de chaque arête de maille est disposé un plot 5a, 5b de thermocouple, deux mailles 17 adjacentes ayant deux plots en commun.

Chaque maille comporte un trou débouchant dont l'axe longitudinal est, de préférence, parallèle aux arêtes de la maille et, de préférence situé à équidistance des arêtes. Autrement dit, le trou débouchant 13 peut avoir la forme d'un cylindre circulaire droit. Les éléments de liaison et de connexion (non représentés) sont localisés respectivement sur ou au niveau de la première face active et la deuxième face active.

Afin d'optimiser la géométrie, chaque maille 17 élémentaire du mode de réalisation de la figure 7 a une surface de section de maille dans le plan de la feuille sur la figure 7 de x$^2$, la surface de la section d'un plot, dans le même plan, est définie par $\pi*r^2$, r étant le rayon de la section du plot si ce dernier a une section en forme de cercle. Le rayon maximal $r_{max}$ d'un plot est inférieur à x/2 pour éviter le contact latéral entre plots. Ceci définit la surface maximale de plots intégrables soit $S_{maxptot}$ = $\pi*r_{max}^2$ = 78,5% de la surface de la maille dans le cas d'une maille de section carrée.

Le trou débouchant 13, lorsqu'il a une forme de cylindre circulaire droit dans la maille définit une surface de passage de $\pi R^2$, R étant le rayon du trou 13 percé dans le substrat 14. Les limitations de réalisation géométriques limitent la valeur de R à une valeur maximale définie en fonction de x et de r. Ainsi, le rayon maximum $R_{max}$ du trou est égal à $\dfrac{x}{2} - r$. Des éléments électriquement conducteurs sont réalisés au niveau de la première face active et de la seconde face active pour former les éléments de connexion et les éléments de liaison (non visibles sur la figure 7) et relier les plots entre eux. Pour des raisons géométriques, le rayon maximum $r_{max}$ des plots sera bien entendu strictement inférieur à $\dfrac{x}{2}$.

En considérant un élément de liaison ou de connexion dont la dimension longitudinale correspond à la distance séparant deux plots reliés électriquement en série, la largeur d'un tel élément est, de préférence, inférieure à deux fois le rayon de la section d'un plot, et l'élément est agencé de sorte à ne pas obstruer le trou débouchant.

La figure 8 représente une vue en coupe du module thermoélectrique selon un deuxième mode de réalisation, ce dernier comporte une série de trous 13 en quinconce reliant la première face active du module à la deuxième face active du module, c'est-à-dire des trous débouchant, un plot 5a, 5b de thermocouple étant adjacent à trois trous 13 (à l'exception des plots de rive du module). Ce mode de réalisation peut être mis en oeuvre en subdivisant virtuellement en mailles 17 élémentaires le substrat 14 dans lequel sont formés les thermocouples. Sur la figure 8, les mailles 17 sont formées par un cylindre dont la courbe directrice forme un hexagone régulier définissant au niveau de chaque maille 17 six arêtes de maille reliant la première face active à la deuxième face active. Autrement dit, chaque maille comporte six faces latérales reliant la première face active à la deuxième face active. Au niveau de chaque arête de maille est disposé un plot 5a, 5b de thermocouple, deux mailles adjacentes ayant deux faces latérales accolées et deux plots 5a, 5b en commun. Chaque maille 17 comporte un trou débouchant 13 dont l'axe longitudinal est, de préférence, parallèle aux arêtes de maille et, de préférence, situé à équidistance des arêtes de maille. Autrement dit, le trou débouchant peut avoir la forme d'un cylindre circulaire droit.

En travaillant à surface de maille identique au premier mode de réalisation, on obtient une surface de maille $x^2 = 3^{3/2}a^2+2$ soit $a = 2^{1/2}x+3^{3/4}$ avec a la distance séparant deux arêtes adjacentes d'une même face latérale de maille, c'est-à-dire la longueur d'un côté de l'hexagone.

Afin d'optimiser la géométrie, chaque maille élémentaire du mode de réalisation de la figure 8 a une section de surface de maille dans le plan de la feuille sur la figure 8 de $x^2$ (surface constante au premier mode de réalisation), la surface de la section d'un plot dans le plan de la figure est définie par $\pi*r^2$, r étant le rayon d'un plot si ce dernier a une section en forme de cercle. Le rayon maximal d'un plot est inférieur à a/2 pour éviter le contact entre deux plots. Ceci définit la surface maximale de thermocouples intégrables soit 60,4% de la surface dans le cas d'une maille de section hexagonale.

Comme pour le premier mode de réalisation, le trou débouchant 13, lorsqu'il a une forme de cylindre circulaire droit dans la maille définit une section dont la surface de passage est de $\pi*R^2$, R étant le rayon du trou percé dans le substrat 14. Les limitations de réalisation géométriques limitent la valeur de R à une valeur maximale définie en fonction de x, de a et de r. Ainsi, le rayon maximum $R_{max}$ du trou est égal à a-r soit 0,62x-r. Des éléments électriquement conducteurs (non représentés) sont réalisés au niveau de la première face active et de la deuxième face active pour former les éléments de connexion et les éléments de liaison. Pour des raisons géométriques, le rayon maximum des plots sera strictement inférieur à $\dfrac{a}{2}$ soit 0,31 x.

Ainsi, une section de maille hexagonale permet une section de passage de fluide supérieur à la maille carrée.

Pour une même unité de surface $x^2$, l'agencement sous forme de mailles hexagonales permet d'obtenir une section de passage du fluide toujours supérieure à celle d'une maille de section carrée. De plus, la maille de section hexagonale est plus compacte que la géométrie à base de mailles de section carrée, dès lors elle permet d'intégrer plus de thermocouples au sein d'un même module.

De préférence, le substrat 14 du module thermoélectrique a une conductivité thermique k supérieure à celle de l'air (k=0,17 W/m.K pour les polyimides les plus performants, à comparer avec la conductivité thermique de l'air de 0,024W/m.K). Ainsi, dans le cas où le fluide a une conductivité inférieure à celle du substrat, plus le substrat 14 sera percé, plus la conductivité thermique moyenne du module thermoélectrique sera faible à taux de remplissage de thermocouples constant, et plus le gradient thermique entre les deux faces actives du module thermoélectrique sera grand. Ainsi, il en résulte des performances accrues pour le mode de réalisation avec mailles de sections hexagonales.

Pour un matériau donné, une hauteur de thermocouples donnée, et un gradient de température donné, il peut exister un optimum de taux de remplissage thermoélectrique (nombre de thermocouples) pour optimiser les performances en termes de puissance délivrée par le module. Ce taux de remplissage peut s'avérer supérieur au taux maximal de 60,4% défini par la géométrie hexagonale. Dès lors il faudra chercher un compromis optimal entre la puissance générée par le module thermoélectrique et les pertes de charge induites sur la circulation du fluide. Autrement dit, si l'on cherche à obtenir un taux inférieur à 60,4% on favorisera la structure à maille de section hexagonale, et si l'on cherche à obtenir un taux supérieur à 60,4%, on favorisera la structure à maille carrée, en fait tout dépend de la géométrie désirée du module et des plots. La géométrie à section hexagonale est celle qui limite le plus la perturbation de l'écoulement du fluide.

Le second mode de réalisation à base de mailles 17 de sections hexagonales régulières permet de réaliser un dispositif de manière simplifiée en évitant les problématiques de l'auto-alignement. En effet, grâce à une telle géométrie, à l'exception des mailles situées en rives du module thermoélectrique 2, une droite d1 passant par deux plots adjacents 5a, 5b d'une même face de maille 17 va déboucher de part et d'autre de ces deux plots dans un trou 13 avant de rencontrer à nouveau un autre plot.

Le procédé de fabrication du module peut être réalisé à base de matériaux massifs ou de pâtes thermoélectriques.

Dans le cas de matériaux massifs, on localise et on forme tout d'abord les différents plots 5a, 5b du futur module thermoélectrique 2 au niveau des arêtes de chaque maille 17 hexagonale, deux mailles 17 adjacentes ayant deux plots en commun et deux faces latérales accolées. Deux plots adjacents d'une même face de maille sont, de préférence, formés dans des matériaux différents. De préférence l'un des matériaux est dopé de type P et l'autre de type N. Ainsi, chaque maille 17 comporte six plots dont trois sont dopés type P et trois dopés type N, les plots d'une maille étant alternativement dopés P et N.

Après formation des plots 5a, 5b, ces derniers sont noyés dans un polymère qui est choisi pour avoir une faible conductivité thermique k, comme par exemple la résine époxy haute température (k<0,5W/m.K), afin de maximiser le gradient thermique entre les deux faces actives du futur module thermoélectrique. Après le polymère mis en forme, par exemple par solidification, par recuit, par réticulation sous UV, ou autre, il sera, si nécessaire, poli de sorte que les extrémités distales de chaque plot affleurent sur deux faces opposées du module (futures faces actives).

Ensuite, des connexions électriques sont réalisées sur une première face du module où affleurent les plots. Une étape consiste à réaliser des lignes parallèles (selon d1 à la figure 8) en matériau électriquement conducteur sur la première face du substrat 14, ces lignes peuvent être réalisées par des techniques d'impression ou de dépôt compatible avec les matériaux du module. La largeur de chaque ligne sera strictement non nulle pour permettre le passage du courant et inférieure ou égale au diamètre des plots. Une ligne passe par au moins deux plots associés à une même face latérale de la maille. Le pas séparant deux lignes parallèles adjacentes est égal à $\dfrac{\sqrt{3}}{2} \times a$ où a définit la longueur d'un des côtés de l'hexagone.

D'autres connexions électriques sont ensuite réalisées sur une deuxième face du module opposée à la première face, ces connexions peuvent être réalisées par des lignes d2 en matériau métallique ou plus généralement électriquement conducteur, ces lignes d2 étant parallèles entre elles au niveau de la deuxième face. Les critères géométriques sont identiques à ceux de la première face, une ligne d1 associée à la première face faisant un angle de $\dfrac{2}{3}\pi$ avec une ligne d2 de la seconde face dans le cas de la structure de maille hexagonale.

Pour finir, le substrat 14 est percé de la première face à la deuxième face, de préférence au niveau de chaque maille 17. Le centre de ces trous 13 correspond, de préférence, au centre des hexagones. Ainsi, les trous coupent automatiquement les lignes de connexions en matériau électriquement conducteur de la première face et de la seconde face lorsque ces dernières coupent diamétralement une maille, définissant spatialement et automatiquement les éléments de connexion et les éléments de liaison du module évoqués précédemment.

Dans le cas où des pâtes thermoélectriques sont utilisées, le procédé diffère de celui décrit ci-dessus pour les étapes de formation de plots de type P et de type N, et de l'étape de moulage qui sont remplacées par une première étape de perçage d'ouverture dans un substrat 14 choisi pour avoir une faible conductivité thermique k, comme par exemple un substrat à base de polyimide (k<0,17W/K.m), de sorte à délimiter les emplacements des futurs plots 5a, 5b. Les ouvertures sont alors formées en alignement avec les arêtes de chaque maille. Deux mailles 17 adjacentes sont accolées au niveau de deux faces latérales respectives, et ont deux ouvertures/futurs plots 5a, 5b en commun. Les plots 5a, 5b, de préférence de type P et de type N sont ensuite réalisés dans les ouvertures formées dans le substrat 14 aux emplacements des arêtes par des technologies d'impression comme le jet d'encre, la dispense par micro-valve, le spray ou encore la sérigraphie. Dans le cas où le spray, ou la sérigraphie, est utilisé, il est nécessaire de former au préalable un masque discriminant les ouvertures devant être remplies, de celles devant rester vides. Deux plots 5a, 5b adjacents d'une même face latérale du cylindre de section hexagonale sont formés, de préférence, dans des matériaux différents, l'un des matériaux est, de préférence, dopé de type P et l'autre de type N. Ainsi, chaque maille comporte six plots dont trois sont dopés type P et trois dopés type N.

La suite du procédé reste identique à celui décrit ci-dessus en partant de l'étape de formation des connexions électriques au niveau de la première face.

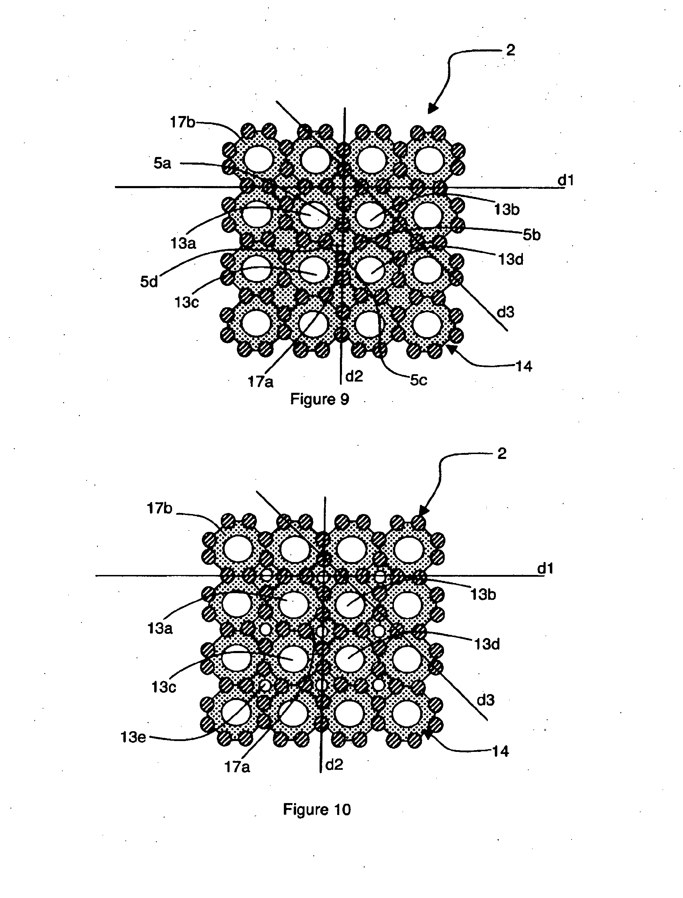

Selon un autre mode de réalisation illustré à la figure 9, le module 2 comporte une matrice de trous reliant la première face active à la deuxième face active. Un ensemble de quatre plots 5a, 5b, 5c, 5d de thermocouples est entouré par quatre trous 13a, 13b, 13c, 13d, chaque plot de l'ensemble étant adjacent à deux trous de ces quatre trous. Ce mode de réalisation peut être mis en oeuvre par l'arrangement particulier de la figure 9. Ainsi, le substrat 14 peut être subdivisé virtuellement en mailles élémentaires formées par des cylindres 17a dont la courbe directrice forme un carré (quatre faces latérales reliant la première face active et la seconde face active) et des cylindres 17b dont la courbe directrice forme un octogone régulier (huit faces latérales reliant la première face active et la seconde face active). Sur la figure 9, ces cylindres sont accolés les uns aux autres et divisent virtuellement un substrat monobloc. Ainsi, à l'exception des cylindres de rives, un cylindre octogonal est adjacent à quatre autres cylindres octogonaux, c'est-à-dire que quatre de ses faces latérales, deux à deux opposées, sont en contact avec des faces latérales complémentaires d'un autre cylindre octogonal. Les deux premières faces latérales opposées sont situées dans des plans parallèles et les deux secondes faces opposées latérales sont situées dans des plans parallèles et perpendiculaires aux plans des premières faces opposées. Les autres faces latérales du cylindre octogonal sont chacune en contact avec une face latérale d'un cylindre de section carrée. Des plots 5a, 5b, 5c, 5d sont formés en matériau de type P ou de type N au niveau des arêtes du cylindre octogonal, chaque plot étant commun à deux arêtes de deux cylindres octogonaux adjacents et à une arête de cylindre de section carrée (à l'exception des cylindres de rive). Les mailles formées par les cylindres octogonaux comportent chacune un trou débouchant 13a reliant deux faces opposées du module. De préférence, les cylindres de forme carrée comportent eux aussi un trou débouchant 13e comme illustré à la figure 10.

Ce mode de réalisation peut être obtenu grâce au procédé décrit ci-dessus à la différence près que chaque cylindre octogonal comporte huit plots répartis au niveau des arêtes sur le pourtour du cylindre octogonal par une succession de deux plots de type N, un plot de type P, un plot de type N, deux plots de type P, un plot de type N et un plot de type P. Ensuite, les connexions entre plots sont formées sur la première face du module et comportent la réalisation de deux réseaux de lignes denses en matériau électriquement conducteur. Dans le premier réseau de lignes d1, sensiblement parallèles entre elles et passant par deux plots d'une même face de maille octogonale avant de traverser diamétralement une maille de section carrée, deux lignes adjacentes sont séparées par une distance sensiblement égale à la distance séparant deux faces latérales opposées du cylindre de section octogonale. De la même manière dans le deuxième réseau de lignes d2, sensiblement parallèles entre elles et passant par deux plots d'une même face de maille octogonale avant de traverser diamétralement une maille de section carrée, deux lignes adjacentes sont séparées par une distance sensiblement égale à la distance séparant deux faces latérales opposées du cylindre de section octogonale. Les premier et deuxième réseaux sont sensiblement perpendiculaires entre eux. Les connexions formées sur la deuxième face du module comportent un troisième réseau de lignes d3 parallèles entre elles, et réalisées dans un matériau électriquement conducteur. Chaque ligne du troisième réseau passe au moins par deux plots associé à une même face d'un cylindre de section octogonale. Les lignes d3 de la deuxième face du module font un angle de $\dfrac{3\pi}{4}$ par rapport aux lignes du premier réseau et du second réseau de la première face du module. Les lignes d3 parallèles du troisième réseau sont successivement et cycliquement séparées par une distance égale à $\dfrac{a}{\sqrt{2}}$ puis a, a étant la longueur d'un côté de l'octogone.

Les trous débouchant pratiqués dans les cylindres de section octogonale, ont, de préférence, un diamètre suffisant pour couper les lignes de la deuxième face du module au niveau de chaque cylindre de section octogonale. Le cas échéant, les trous pratiqués dans les cylindres de section carrée permettent de couper les lignes des premier et second réseaux.

Le dispositif tel que décrit permet d'instrumenter de larges surfaces pour récupérer de l'énergie. La réalisation de composants thermoélectriques de grande surface pour des applications de récupération d'énergie à base de chaleur de faible grade permet d'atteindre des rendements raisonnables. De plus, la fabrication utilisant les techniques d'impression à bas coûts permet l'utilisation de tout type de substrats, y compris les substrats polymères flexibles.

## Revendications

1.  Dispositif de génération de courant et/ou de tension comportant :

    - des moyens pour faire circuler un fluide entre une entrée (9) et une sortie (10) du dispositif,
    - un module thermoélectrique (2) comportant une première face active (11) exposée au fluide, le module thermoélectrique (2) étant ajouré et disposé dans le chemin du fluide entre l'entrée (9) et la sortie (10) du dispositif, la première face active (11) étant sensiblement perpendiculaire à la direction d'écoulement du fluide,

    **caractérisé en ce que** le module thermoélectrique (2) comprend des thermocouples (3a, 3b), chaque thermocouple (3a, 3b) comportant deux plots (5a, 5b) électriquement conducteurs reliés électriquement entre eux au niveau de la première face active (11) du module thermoélectrique (2) pour former une jonction chaude ou froide associée, les thermocouples (3a, 3b) étant reliés électriquement en série au niveau d'une deuxième face active (12) du module pour former des jonctions complémentaires, et **en ce que** les thermocouples sont intégrés dans un substrat (14) isolant thermiquement, le module thermoélectrique (2) étant ajouré par des trous débouchant (13) réalisés dans le substrat (14).

2.  Dispositif selon la revendication 1, **caractérisé en ce qu'**il comporte un échangeur thermique (7) en contact thermique avec la deuxième face active du module thermoélectrique (2).

3.  Dispositif selon la revendication 2 **caractérisé en ce que** l'échangeur thermique (7) comprend un radiateur à circulation d'eau.

4.  Dispositif selon l'une quelconque des revendications 1 à 3 **caractérisé en ce qu'**il comporte des moyens d'échange thermique (15) disposés au niveau de la première face active (11).

5. Dispositif selon l'une des revendications 1 à 4, **caractérisé en ce que** le module (2) comporte une matrice de trous (13) reliant la première face active (11) à la deuxième face active (12), un plot (5a, 5b) de thermocouple étant adjacent à quatre trous (13).

6. Dispositif selon l'une des revendications 1 à 4, **caractérisé en ce que** le module (2) comporte une série de trous (13) en quinconce reliant la première face active (11) à la deuxième face active (12), un plot de thermocouple étant adjacent à trois trous (13).

7. Dispositif selon l'une des revendications 1 à 4, **caractérisé en ce que** le module (2) comporte une matrice de trous reliant la première face active (11) à la deuxième face active (12), un ensemble de quatre plots (5a, 5b, 5c, 5d) de thermocouples étant entouré par quatre trous (13), chaque plot (5a, 5b, 5c, 5d) étant adjacent à deux trous (13) de ces quatre trous (13).


**Patentansprüche**

1. Vorrichtung zur Erzeugung von Strom und/oder Spannung mit:

   - Einrichtungen zum Zirkulieren einer Flüssigkeit zwischen einem Eingang (9) und einem Ausgang (10) der Vorrichtung,
   - einem thermoelektrischen Modul (2) mit einer der Flüssigkeit ausgesetzten, ersten wirksamen Fläche (11), wobei das thermoelektrische Modul (2) durchbrochen und in dem Flüssigkeitspfad zwischen dem Eingang (9) und dem Ausgang (10) der Vorrichtung angebracht ist, wobei die erste wirksame Fläche (11) in etwa senkrecht zur Fließrichtung der Flüssigkeit steht,

   **dadurch gekennzeichnet, dass** das thermoelektrische Modul (2) Thermoelemente (3a, 3b) umfasst, wobei jedes Thermoelement (3a, 3b) zwei elektrisch leitende Kontakte (5a, 5b) aufweist, die miteinander auf der Höhe der ersten wirksamen Fläche (11) des thermoelektrischen Moduls (2) elektrisch verbunden sind, um einen zugeordneten heißen oder kalten Übergang zu bilden, wobei die Thermoelemente (3a, 3b) zur Ausbildung von komplementären Übergängen elektrisch auf der Höhe einer zweiten wirksamen Fläche (12) des Moduls in Reihe geschaltet sind, und dass die Thermoelemente in ein wärmeisolierendes Substrat (14) integriert sind, wobei das thermoelektrische Modul (2) von Mündungsöffnungen (13) durchbrochen ist, die in dem Substrat (14) ausgebildet sind.

2. Vorrichtung gemäß Anspruch 1, **dadurch gekenn-** **zeichnet, dass** sie einen Wärmetauscher (7) in Wärmekontakt mit der zweiten wirksamen Fläche des thermoelektrischen Moduls (2) aufweist.

3. Vorrichtung gemäß Anspruch 2, **dadurch gekennzeichnet, dass** der Wärmetauscher (7) einen Wasserkreislaufkühler umfasst.

4. Vorrichtung gemäß einem der Ansprüche 1 bis 3, **dadurch gekennzeichnet, dass** sie Wärmeaustauscheinrichtungen (15) umfasst, die auf der Höhe der ersten wirksamen Fläche (11) angeordnet sind.

5. Vorrichtung gemäß einem der Ansprüche 1 bis 4, **dadurch gekennzeichnet, dass** das Modul (2) eine Lochmatrix (13) aufweist, die die erste wirksame Fläche (11) mit der zweiten wirksamen Fläche (12) verbindet, wobei ein Kontakt (5a, 5b) des Thermoelements an vier Löcher (13) angrenzt.

6. Vorrichtung gemäß einem der Ansprüche 1 bis 4, **dadurch gekennzeichnet, dass** das Modul (2) eine Reihe von versetzt angeordneten Löchern (13) umfasst, die die erste wirksame Fläche (11) mit der zweiten wirksamen Fläche (12) verbinden, wobei ein Kontakt des Thermoelements an drei Löcher (13) angrenzt.

7. Vorrichtung gemäß einem der Ansprüche 1 bis 4, **dadurch gekennzeichnet, dass** das Modul (2) eine Lochmatrix umfasst, die die erste wirksame Fläche (11) mit der zweiten wirksamen Fläche (12) verbindet, wobei eine Einheit mit vier Kontakten (5a, 5b, 5c, 5d) von Thermoelementen von vier Löchern (13) umgeben ist, wobei jeder Kontakt (5a, 5b, 5c, 5d) an zwei (13) dieser vier Löcher (13) angrenzt.


**Claims**

1. A device for generating current and/or voltage comprising:

   - means for making a fluid flow between an inlet (9) and an outlet (10) of the device,
   - a thermoelectric module (2) comprising a first active surface (11) exposed to the fluid, the thermoelectric module (2) comprising apertures and being placed in the path of the fluid between the inlet (9) and the outlet (10) of the device, the first active surface (11) being substantially perpendicular to the direction of flow of the fluid,

   **characterized in that** the thermoelectric module (2) comprises thermocouples (3a, 3b), each thermocouple (3a, 3b) comprising two electrically conducting bumps (5a, 5b) electrically connected to one another at the level of the first active surface (11) of the thermoelectric module (2) to form an associated hot or cold junction, the thermocouples (3a, 3b) being electrically connected in series at the level of a second active surface (12) of the module to form complementary junctions, and **in that** the thermocouples are integrated in a thermally insulating substrate (14), the thermoelectric module (2) being perforated by pass-through apertures (13) made in the substrate (14).

2. The device according to claim 1, **characterized in that** it comprises a heat exchanger (7) in thermal contact with the second active surface of the thermoelectric module (2).

3. The device according to claim 2, **characterized in that** the heat exchanger (7) comprises a water circulation heat sink.

4. The device according to any one of claims 1 to 3, **characterized in that** it comprises heat exchange means (15) arranged at the level of the first active surface (11).

5. The device according to one of claims 1 to 4, **characterized in that** the module (2) comprises a matrix of holes (13) connecting the first active surface (11) to the second active surface (12), a thermocouple bump (5a, 5b) being adjacent to four holes (13).

6. The device according to one of claims 1 to 4, **characterized in that** the module (2) comprises a series of staggered holes (13) connecting the first active surface (11) to the second active surface (12), a thermocouple bump being adjacent to three holes (13).

7. The device according to one of claims 1 to 4, **characterized in that** the module (2) comprises a matrix of holes connecting the first active surface (11) to the second active surface (12), a set of four thermocouple bumps (5a, 5b, 5c, 5d) being surrounded by four holes (13), each bump (5a, 5b, 5c, 5d) being adjacent to two holes (13) of these four holes (13).

Figure 1 (art antérieur)

Figure 2

Figure 3

Figure 4

Figure 5

Figure 6

Figure 7

Figure 8

Figure 9

Figure 10

**RÉFÉRENCES CITÉES DANS LA DESCRIPTION**

**Documents brevets cités dans la description**

- JP 2001065858 B